(19) Europäisches Patentamt
European Patent Office
Office européen des brevets

(11) **EP 3 641 137 B1**

(12) **EUROPÄISCHE PATENTSCHRIFT**

(45) Veröffentlichungstag und Bekanntmachung des Hinweises auf die Patenterteilung:
**05.06.2024  Patentblatt 2024/23**

(21) Anmeldenummer: **18201484.5**

(22) Anmeldetag: **19.10.2018**

(51) Internationale Patentklassifikation (IPC):
**H03M 7/14** *(2006.01)*        **H03M 7/18** *(2006.01)*

(52) Gemeinsame Patentklassifikation (CPC):
**H03M 7/14; H03M 7/18**

(54) **VERFAHREN UND VORRICHTUNG ZUM VERARBEITEN VON DATEN**

DEVICE AND METHOD FOR PROCESSING DATA

DISPOSITIF ET PROCÉDÉ DE TRAITEMENT DE DONNÉES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**22.04.2020  Patentblatt 2020/17**

(73) Patentinhaber: **Siemens Aktiengesellschaft**
**80333 München (DE)**

(72) Erfinder: **Walter, Maximilian**
**90408 Nürnberg (DE)**

(74) Vertreter: **Siemens Patent Attorneys**
**Postfach 22 16 34**
**80506 München (DE)**

(56) Entgegenhaltungen:
• **Ute Schiffel: "Hardware Error Detection Using AN-Codes", internet article, 10. Juni 2011 (2011-06-10), XP002790843, Gefunden im Internet: URL:https://d-nb.info/1067189289/34 [gefunden am 2019-04-25]**

**Beschreibung**

Die vorliegende Erfindung betrifft ein Verfahren sowie ein Computerprogrammprodukt zum Verarbeiten von Daten. Des Weiteren betrifft die vorliegende Erfindung eine Vorrichtung zum Verarbeiten von Daten sowie eine funktional sichere, programmierbare Steuerung mit einer solchen Vorrichtung.

Das technische Gebiet der Erfindung betrifft die Verarbeitung von Daten, insbesondere die Kombination von uncodierter und codierter Verarbeitung von Daten.

Funktional sichere Systeme werden zur Reduktion von Risiken für Gesundheit und Leben sowie zur Vermeidung von Umweltschäden eingesetzt. Neben der sicheren Erfassung und Kommunikation von Prozessinformationen erfordern diese eine sichere Verarbeitung, z.B. in speicherprogrammierbaren Steuerungen oder im Industrie-PC.

In funktional sicheren Systemen sollen Fehler bei der Speicherung, Übertragung und Verarbeitung von Daten mit hoher Wahrscheinlichkeit erkannt werden. Dies soll auch möglich sein, wenn das funktional sichere System nicht nur Ganzzahlen, sondern auch reelle Zahlen verarbeitet.

Reelle Zahlen können mittels Ganzzahlen approximiert werden. Hierbei sind zur Darstellung von reellen Zahlen die Festkomma-Arithmetik, Gleitkomma-Arithmetik und Brüche bekannt.

Von diesen Darstellungsmöglichkeiten ist die Gleitkomma-Arithmetik am geeignetsten, da Überläufe praktisch nicht auftreten können und Rundungsfehler im Vergleich zu den anderen Darstellungsmöglichkeiten leichter beherrschbar sind.

Die Gleitkomma-Arithmetik wird in Kombination mit einer ANBD-Codierung bei der Anwendung in funktional sicheren Systemen verwendet, um die Daten in einer codierten Form zu verarbeiten, damit die Daten vor Fehlern und einer unerkannten Veränderung geschützt werden können.

Bei der ANBD-Codierung handelt es sich um eine arithmetische Codierung, bei welcher beispielsweise eine Gleitkommazahl oder Gleitkomma-Arithmetik-Operationen (GAO) über eine Vorschrift in eine arithmetisch codierte Zahl überführt wird. Die ANBD-Codierung ist beispielsweise aus der Druckschrift EP 3 104 276 A1 bekannt.

Diese Überführung mittels der Vorschrift beinhaltet jedoch eine Umwandlung von den eingehenden Gleitkomma-Arithmetik-Operationen mit Hilfe einer Software in Ganzzahl-Operationen. Dies liegt daran, dass die ANBD-Codierung lediglich für Ganzzahl-Operationen, aber nicht für GAO verwendet werden kann, da die verwendeten Prozessoren (Floating Point Units (FPUs)) keine codierte Verarbeitung mittels Gleitkomma-Arithmetik unterstützen.

Das hat den Nachteil, dass sich ein hoher Performance-Overhead bei der Verarbeitung codierter Gleitkommazahlen ergibt, da für eine Gleitkomma-Arithmetik-Operation eine Vielzahl von Ganzzahl-Operationen ausgeführt werden muss.

Ein Artikel "Hardware Error Detection Using AN-Codes", Dissertation [aus dem Internet], Ute Schiffel, [veröffentlicht am 10. Juni 2011], empfangen am 15. Juli 2018 von <https://d-nb.info/1067189289/34>, offenbart verschiedene arithmetische Codes, wie AN-Codes, ANB-Codes und ANBD-Codes, welche unter einem Aspekt der "Hardware Error Detection" untereinander verglichen werden.

Demnach besteht eine Aufgabe der vorliegenden Erfindung darin, die Verarbeitung von Daten zu verbessern.

Gemäß einem ersten Aspekt wird ein Verfahren zum Verarbeiten von Daten vorgeschlagen. Dabei wird eine uncodierte reelle Zahl x in eine LNS-codierte Ganzzahl $x_{LNS}$ mittels einer vorbestimmten Wandelvorschrift für ein logarithmisches Zahlensystem, LNS (LNS; Logarithmic number system), gemäß der Gleichung (1)

$$x_{LNS} = \text{sgn}(x) \cdot 2^m + \text{ld}|x| \cdot 2^n \qquad (1)$$

gewandelt, wobei sgn(x) eine Vorzeichenfunktion der uncodierten reellen Zahl x, ld|x| einen Zweierlogarithmus der uncodierten reellen Zahl x, m einen ersten Exponenten und n einen zweiten Exponenten bezeichnen, und die LNS-codierte Ganzzahl $x_{LNS}$ wird mittels einer arithmetischen Codierung in eine arithmetisch codierte Ganzzahl $x_c$ codiert.

Der Wandelschritt der uncodierten reellen Zahl x in eine LNS-codierte Ganzzahl $x_{LNS}$ mittels der Wandelvorschrift kann auch als LNS-Codierung bezeichnet werden.

Durch die LNS-Codierung in Verbindung mit der arithmetischen Codierung ergibt sich eine erhebliche Verringerung der benötigten Ganzzahl-Operationen im Vergleich zu der Verwendung der Kombination aus Gleitkomma-Arithmetik-Operationen und arithmetischer Codierung.

Das hat den Grund, dass bei der Kombination aus LNS-Codierung und arithmetischer Codierung eine reelle Zahl in einer Ganzzahl gespeichert und verarbeitet werden kann. Im Detail wird für eine Umwandlung einer reellen Zahl eine LNS-codierte Ganzzahl $x_{LNS}$ bzw. eine Ganzzahl-Operation benötigt.

Dadurch weist die Kombination aus LNS-Codierung und arithmetischer Codierung den technischen Effekt auf, dass sich durch die Verringerung der benötigen Ganzzahl-Operationen, im Vergleich zu der aus dem Stand der Technik bekannten Kombination aus Gleitkomma-Arithmetik-Operationen und arithmetischer Codierung, der Performance-Overhead erheblich verringert, da für eine Wandlung und Codierung einer uncodierten reellen Zahl in eine arithmetisch codierte Ganzzahl weniger Ganzzahl-Operationen benötigt werden. Insbesondere werden für die Verarbeitung arithmetisch codierter LNS-Zahlen weniger Ganzzahl-Operationen als für die Verarbeitung arithmetisch codierter Gleitkommazahlen benötigt.

Somit kann eine verbesserte Performance im Vergleich zu der Kombination aus Gleitkomma-Arithmetik-Operationen und arithmetischer Codierung bei gleichzeitig verringerter notwendiger Rechenleistung erzielt werden. Da Hardware mit verringerter Rechenleistung eingesetzt werden kann, können die Hardwarekosten gesenkt werden.

LNS ist die englische Bezeichnung für "Logarithmic Number System" und wird im Folgenden in deutscher Sprache als logarithmisches Zahlensystem, LNS, bezeichnet, welches zur Darstellung von reellen Zahlen verwendet wird. Hinsichtlich LNS wird auf die Referenzen [1] bis [7] verwiesen.

x ist eine uncodierte reelle Zahl. x umfasst somit den Zahlenbereich der reellen Zahlen, also beispielsweise rationale und irrationale Zahlen.

$x_{LNS}$ ist eine vorzugsweise LNS-codierte reelle Zahl, gespeichert als Ganzzahl. Eine Ganzzahl ist gleichgestellt mit dem Begriff ganze Zahl und ist eine Untermenge der reellen Zahlen. $x_{LNS}$ ist beispielsweise gerundet.

x wird mithilfe der LNS-Codierung in eine LNS-codierte Ganzzahl $x_{LNS}$ über die oben definierte Gleichung (1) gewandelt.

Die Exponenten m und n der Gleichung (1) dienen zur Einstellung des Wertebereichs und damit auch zur Bestimmung der Wortbreite (z.B. 32 oder 64 Bit) der zu verarbeitenden Ganzzahl. m und n können als Ganzzahl dargestellt werden.

$x_c$ ist eine arithmetisch codierte Ganzzahl. Eine LNS-codierte Ganzzahl $x_{LNS}$ wird mittels einer arithmetischen Codierung in eine arithmetisch codierte Ganzzahl $x_c$ codiert. Die arithmetische Codierung dient dazu, die LNS-codierte Ganzzahl $x_{LNS}$ um verschiedene Prüfbits zu erweitern, um bestimmte auftretende Fehler erkennen zu können.

Beispielsweise können mit der arithmetischen Codierung unter anderem Fehler im Wertebereich, Operanden- und Operatorenfehler oder nicht aktualisierte Variablen, welche verwendet werden, erkannt werden.

Gemäß einer Ausführungsform wird die reelle Zahl x als eine Ganzzahl von einem Sensor oder als eine Fließkommazahl von dem Sensor oder als eine Fließkommazahl oder als ein String durch eine Eingabe eines Benutzers oder als Konstante eines Programmcodes erhalten.

Die reelle Zahl x kann als eine Ganzzahl von einem Sensor erhalten werden. Ein von einem Sensor erhaltener analoger Wert wird über einen A/D-Wandler digitalisiert und kann dann beispielsweise als Ganzzahl oder als Fließkommazahl zur weiteren Verarbeitung zur Verfügung gestellt werden. Die reelle Zahl x kann auch als Fließkommazahl oder als Bruch erhalten werden. Zudem kann die reelle Zahl x mittels einer Eingabe eines Benutzers als String oder als Konstante eines Programmcodes erhalten werden.

Gemäß einer weiteren Ausführungsform wird die uncodierte reelle Zahl x während eines Kompiliervorgangs zu der LNS-codierten Ganzzahl $x_{LNS}$ gewandelt.

Gemäß einer weiteren Ausführungsform wird die LNS-codierte Ganzzahl $x_{LNS}$ während eines Kompiliervorgangs zu der arithmetisch codierten Ganzzahl $x_c$ codiert.

Gemäß einer weiteren Ausführungsform wird eine Anzahl N, mit N $\geq$ 1, von uncodierten reellen Zahlen x, y mittels der vorbestimmten Wandelvorschrift in eine entsprechende Anzahl N von LNS-codierten Ganzzahlen $x_{LNS}$, $y_{LNS}$ gewandelt, die Anzahl N von LNS-codierten Ganzzahlen $x_{LNS}$, $y_{LNS}$ wird mittels der arithmetischen Codierung in die entsprechende Anzahl N von arithmetisch codierten Ganzzahlen $x_c$, $y_c$ codiert, und zumindest eine codierte Operation wird auf die Anzahl N von arithmetisch codierten Ganzzahlen $x_c$, $y_c$ angewendet. Dies hat insbesondere weitere codierte Ganzzahlen zum Ergebnis.

Codierte Operationen umfassen beispielsweise arithmetisch codierte Operationen. Eine arithmetische Operation ist beispielsweise eine ADD-, SUB-, MUL- oder MOV-Operation. Eine arithmetisch codierte Operation ist beispielsweise CADD, CSUB, CMUL oder CMOV, wobei das C bei der CADD-Operation und den anderen arithmetisch codierten Operationen angibt, dass es sich um eine arithmetisch codierte Operation handelt.

Gemäß einer weiteren Ausführungsform wird als die arithmetische Codierung eine ANBD-Codierung verwendet, welche die LNS-codierte Ganzzahl $x_{LNS}$ mittels einer Eingangskonstanten A, einer variablen-spezifischen Signatur $B_x$ und einer zyklus-spezifischen Signatur D gemäß der Gleichung (2)

$$x_c = A \cdot x_{LNS} + B_x + D \qquad\qquad (2)$$

in die arithmetisch codierte Ganzzahl $x_c$ codiert.

Die ANBD-Codierung weist eine B- und D-Signatur sowie eine Eingangskonstante A auf.

Die Eingangskonstante A ist insbesondere eine ungerade Zahl, bevorzugt eine Primzahl. Die Verwendung der Eingangskonstanten A ermöglicht es, eine Verfälschung von Operanden, beispielsweise Bitkipper, zu verhindern.

D ist eine zyklus-spezifische Signatur D. Zyklus-spezifisch bedeutet in diesem Fall, dass die D-Signatur in einem Zyklus für alle Operanden gleich ist, sich jedoch für einen nächsten oder weiteren Zyklus ändern kann. Dabei entspricht ein Zyklus insbesondere einem Schleifendurchlauf. Mit anderen Worten bedeutet dies, dass innerhalb eines Zyklus der Wert von D für alle Operanden gleich ist, sich aber für einen weiteren Zyklus verändern kann.

Die Verwendung der zyklus-spezifischen Signatur D ermöglicht es, zu erkennen, wenn nicht aktualisierte beziehungsweise veraltete Variablen bei der weiteren Verarbeitung von Daten verwendet werden.

$B_x$ ist eine variablen-spezifische Signatur. Variablen-spezifisch bedeutet in diesem Fall, dass für jede Variable, beispielsweise x, y, z, die zugehörige B-Signatur, also $B_x$, $B_y$ oder $B_z$, einen spezifischen Wert aufweist, welcher abhängig von der jeweiligen Variablen ist. $B_x$ ist zusätzlich vorzugsweise statisch, was bedeutet, dass der Wert von $B_x$, oder von $B_y$ oder von $B_z$, für jeden Zyklus gleich ist. Ferner ist der Wert von $B_x$ für zwei Operanden mit hoher Wahrscheinlichkeit unterschiedlich.

Die Verwendung der variablen-spezifischen Signatur $B_x$ ermöglicht es, Operanden- und Operatorenfehler zu erkennen und zu verhindern. Beispiele für Operandenfehler sind eine Vertauschung von Operanden oder eine Verwendung eines falschen Operanden (zum Beispiel das Lesen einer falschen Adresse). Ein Beispiel für einen Operatorenfehler ist eine Ausführung einer falschen Operation (zum Beispiel AND statt ADD).

Gemäß einer weiteren Ausführungsform umfasst die codierte Operation eine codierte Additions-Operation CADD, bei welcher die arithmetisch codierte Ganzzahl $x_c$, die arithmetisch codierte Ganzzahl $y_c$ und ein erster Parameter $K_1$ unter Verwendung der zyklus-spezifischen Signatur D addiert werden, um ein Ergebnis einer Addition $(x + y)_c$ der arithmetisch codierten Ganzzahlen $x_c$, $y_c$ gemäß der Gleichung (3)

$$(x + y)_c = x_c + y_c + K_1 - D \qquad\qquad (3)$$

zu berechnen, wobei der erste Parameter $K_1$ mittels einer für die arithmetisch codierte Ganzzahl $x_c$ spezifischen Signatur $B_x$, einer für die arithmetisch codierte Ganzzahl $y_c$ spezifischen Signatur $B_y$ und einer für eine arithmetisch codierte Ganzzahl $z_c$ spezifischen Signatur $B_z$ gemäß der Gleichung (4)

$$K_1 = B_{x+y} - B_x - B_z \qquad\qquad (4)$$

berechnet wird.

Gemäß einer weiteren Ausführungsform wird als die arithmetische Codierung eine DNB-Codierung verwendet, welche die LNS-codierte Ganzzahl $x_{LNS}$ mittels einer zyklus-spezifischen Signatur D und einer variablen-spezifischen Signatur $B_x$ gemäß der Gleichung (5)

$$x_c = D \cdot x_{LNS} + B_x \qquad\qquad (5)$$

in die arithmetisch codierte Ganzzahl $x_c$ codiert.

Gemäß einer weiteren Ausführungsform umfasst die codierte Operation eine codierte Additions-Operation CADD, bei welcher die arithmetisch codierte Ganzzahl $x_c$ und die arithmetisch codierte Ganzzahl $y_c$ unter Verwendung eines zweiten Parameters $K_2$ zu einer arithmetisch codierten Ganzzahl $z_c$ gemäß der Gleichung (6)

$$z_c = (x_c + y_c + K_2) \qquad\qquad (6)$$

addiert werden, wobei der zweite Parameter $K_2$ mittels einer für die arithmetisch codierte Ganzzahl $x_c$ spezifischen Signatur $B_x$, einer für die arithmetisch codierte Ganzzahl $y_c$ spezifischen Signatur $B_y$ und einer für die arithmetisch codierte Ganzzahl spezifischen Signatur $B_z$ gemäß der Gleichung (7)

$$K_2 = B_z - B_x - B_y \qquad\qquad (7)$$

berechnet wird.

Gemäß einer weiteren Ausführungsform umfasst die codierte Operation eine codierte Subtraktions-Operation CSUB, bei welcher eine Differenz zwischen der arithmetisch codierten Ganzzahl $x_c$ und der arithmetisch codierten Ganzzahl $y_c$ unter Verwendung eines dritten Parameters $K_3$ zur Bereitstellung einer arithmetisch codierten Ganzzahl $z_c$ gemäß der Gleichung (8)

$$z_c = (x_c - y_c + K_3) \qquad\qquad (8)$$

berechnet wird, wobei der dritte Parameter $K_3$ mittels einer für die arithmetisch codierte Ganzzahl $x_c$ spezifischen Signatur $B_x$, einer für die arithmetisch codierte Ganzzahl $y_c$ spezifischen Signatur $B_y$ und einer für die arithmetisch codierte Ganzzahl spezifischen Signatur $B_z$ gemäß der Gleichung (9)

$$K_3 = B_z - B_x + B_y \qquad\qquad (9)$$

berechnet wird.

Hinsichtlich der Definition der DNB-Codierung und deren codierte Operationen sowie weiteren Beispielen für codierte arithmetische Operationen wird auf die DE 10 2018 189988.1 verwiesen, deren Inhalt hiermit in Bezug genommen wird.

Gemäß einem zweiten Aspekt wird ein Computerprogrammprodukt vorgeschlagen, welches auf einer programmgesteuerten Einrichtung die Durchführung des wie oben erläuterten Verfahrens gemäß dem zweiten Aspekt veranlasst.

Ein Computerprogrammprodukt, wie z.B. ein Computerprogramm-Mittel, kann beispielsweise als Speichermedium, wie z.B. Speicherkarte, USB-Stick, CD-ROM, DVD, Blue-Ray-Disc oder auch in Form einer herunterladbaren Datei von einem Server in einem Netzwerk bereitgestellt oder geliefert werden. Dies kann zum Beispiel in einem drahtlosen Kommunikationsnetzwerk durch die Übertragung einer entsprechenden Datei mit dem Computerprogrammprodukt oder dem Computerprogramm-Mittel erfolgen.

Gemäß einem dritten Aspekt wird eine Vorrichtung zum Verarbeiten von Daten vorgeschlagen. Die Vorrichtung umfasst eine Wandel-Einheit, welche dazu eingerichtet ist, eine uncodierte reelle Zahl x in eine LNS-codierte Ganzzahl $x_{LNS}$ mittels einer vorbestimmten Wandelvorschrift für ein logarithmisches Zahlensystem, LNS, gemäß der Gleichung (10)

$$x_{LNS} = \text{sgn}(x) \cdot 2^m + \text{ld}|x| \cdot 2^n, \qquad\qquad (10)$$

zu wandeln, wobei sgn(x) eine Vorzeichenfunktion der uncodierten reellen Zahl x, ld|x| einen Zweierlogarithmus der uncodierten reellen Zahl x, einen ersten Exponenten m und einen zweiten Exponenten n bezeichnen. Ferner umfasst die Vorrichtung eine Codier-Einheit, welche dazu eingerichtet ist, die LNS-codierte Ganzzahl $x_{LNS}$ mittels einer arithmetischen Codierung in eine arithmetisch codierte Ganzzahl $x_c$ zu codieren.

Die jeweilige Einheit, zum Beispiel die Codier-Einheit, kann hardwaretechnisch und/oder auch softwaretechnisch implementiert sein. Bei einer hardwaretechnischen Implementierung kann die jeweilige Einheit als Vorrichtung oder als Teil einer Vorrichtung, zum Beispiel als Computer oder als Mikroprozessor oder als Steuerrechner eines Fahrzeuges ausgebildet sein. Bei einer softwaretechnischen Implementierung kann die jeweilige Einheit als Computerprogrammprodukt, als eine Funktion, als eine Routine, als Teil eines Programmcodes oder als ausführbares Objekt ausgebildet sein.

Die für das vorgeschlagene Verfahren beschriebenen Ausführungsformen und Merkmale gelten für die vorgeschlagene Vorrichtung entsprechend.

Gemäß einem vierten Aspekt wird eine funktional sichere, programmierbare Steuerung mit einer Vorrichtung gemäß dem dritten Aspekt vorgeschlagen.

Weitere mögliche Implementierungen der Erfindung umfassen auch nicht explizit genannte Kombinationen von zuvor oder im Folgenden bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.

Fig. 1    zeigt ein schematisches Ablaufdiagramm eines Ausführungsbeispiels eines Verfahrens zum Verarbeiten von Daten;

Fig. 2    zeigt ein schematisches Ablaufdiagramm eines weiteren Ausführungsbeispiels eines Verfahrens zum Verarbeiten von Daten mittels codierter Operationen;

Fig. 3    zeigt ein schematisches Ablaufdiagramm eines weiteren Ausführungsbeispiels eines Verfahrens zum Verarbeiten von Daten mittels codierter Operationen;

Fig. 4 zeigt ein schematisches Blockdiagramm eines Ausführungsbeispiels einer Vorrichtung zum Verarbeiten von Daten; und

Fig. 5 zeigt ein schematisches Blockdiagramm eines Ausführungsbeispiels einer funktional sicheren, programmierbaren Steuerung mit der Vorrichtung nach Fig. 4.

In den Figuren sind gleiche oder funktionsgleiche Elemente mit denselben Bezugszeichen versehen worden, sofern nichts anderes angegeben ist.

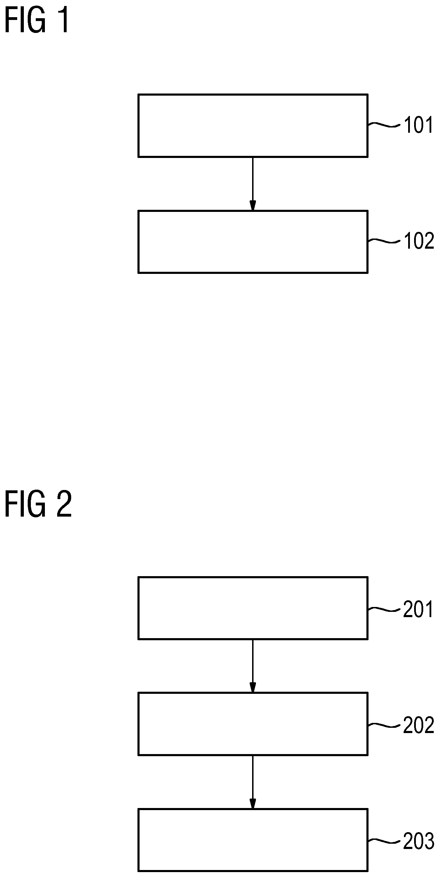

Fig. 1 zeigt ein schematisches Ablaufdiagramm eines Ausführungsbeispiels eines Verfahrens zum Verarbeiten von Daten.

Das Ausführungsbeispiel der Fig. 1 umfasst die folgenden Verfahrensschritte 101 und 102:
In dem Schritt 101 wird eine uncodierte reelle Zahl x in eine LNS-codierte Ganzzahl $x_{LNS}$ gewandelt.

Im Detail wird in Schritt 101 die uncodierte reelle Zahl x in die LNS-codierte Ganzzahl $x_{LNS}$ mittels einer vorbestimmten Wandelvorschrift für ein logarithmisches Zahlensystem, LNS, gemäß der Gleichung (1)

$$x_{LNS} = \text{sgn}(x) \cdot 2^m + ld|x| \cdot 2^n \qquad (1)$$

gewandelt, wobei sgn(x) eine Vorzeichenfunktion der uncodierten reellen Zahl x, ld|x| einen Zweierlogarithmus der uncodierten reellen Zahl x, m einen ersten Exponenten und n einen zweiten Exponenten bezeichnen.

Die reelle Zahl x kann als eine Ganzzahl von einem Sensor oder als eine Fließkommazahl von dem Sensor oder als eine Fließkommazahl oder als ein String durch eine Eingabe eines Benutzers oder als Konstante eines Programmcodes erhalten werden.

Die uncodierte reelle Zahl x wird vorzugsweise während eines Kompiliervorgangs zu der LNS-codierten Ganzzahl $x_{LNS}$ gewandelt.

In dem Schritt 102 wird die LNS-codierte Ganzzahl $x_{LNS}$ mittels einer arithmetischen Codierung in eine arithmetisch codierte Ganzzahl $x_c$ codiert.

Die LNS-codierte Ganzzahl $x_{LNS}$ wird vorzugsweise während eines Kompiliervorgangs zu der arithmetisch codierten Ganzzahl $x_c$ codiert.

Fig. 2 zeigt ein schematisches Ablaufdiagramm eines weiteren Ausführungsbeispiels eines Verfahrens zum Verarbeiten von Daten mittels codierter Operationen.

Das Ausführungsbeispiel der Fig. 2 umfasst die folgenden Verfahrensschritte 201, 202 und 203:
In dem Schritt 201 wird eine Anzahl N von uncodierten reellen Zahlen x, y mittels einer Wandelvorschrift in eine Anzahl N von LNS-codierten Ganzzahlen $x_{LNS}$, $y_{LNS}$ gewandelt.

Weiterhin wird in dem Schritt 202 die Anzahl N von LNS-codierten Ganzzahlen $x_{LNS}$, $y_{LNS}$ mittels der arithmetischen Codierung in die entsprechende Anzahl N von arithmetisch codierten Ganzzahlen $x_c$, $y_c$ codiert.

Die arithmetische Codierung umfasst dabei insbesondere eine ANBD-Codierung, bei welcher die LNS-codierte Ganzzahl $x_{LNS}$ gemäß der Gleichung $x_c = A \cdot x_{LNS} + B_x + D$ in die arithmetisch codierte Ganzzahl $x_c$ codiert wird.

In dem Schritt 203 wird eine codierte Operation auf die Anzahl N von arithmetisch codierten Ganzzahlen $x_c$, $y_c$ angewendet.

Die codierte Operation umfasst dabei insbesondere eine codierte Additions-Operation CADD.

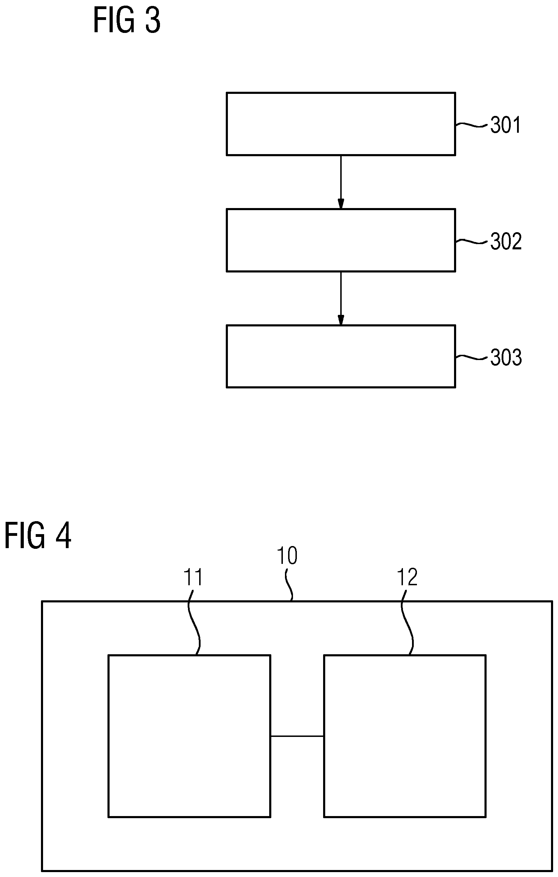

Fig. 3 zeigt ein schematisches Ablaufdiagramm eines weiteren Ausführungsbeispiels eines Verfahrens zum Verarbeiten von Daten mittels codierter Operationen.

Das Ausführungsbeispiel der Fig. 3 umfasst die folgenden Verfahrensschritte 301, 302 und 303:
In dem Schritt 301 wird eine Anzahl N uncodierter reeller Zahlen x, y mittels einer Wandelvorschrift in eine Anzahl N von LNS-codierten Ganzzahlen $x_{LNS}$, $y_{LNS}$ gewandelt.

Weiterhin wird in dem Schritt 302 die Anzahl N von LNS-codierten Ganzzahlen $x_{LNS}$, $y_{LNS}$ mittels der arithmetischen Codierung in die entsprechende Anzahl N von arithmetisch codierten Ganzzahlen $x_c$, $y_c$ codiert.

Die arithmetische Codierung umfasst dabei insbesondere eine DNB-Codierung, welche die LNS-codierte Ganzzahl $x_{LNS}$ gemäß der Gleichung $x_c = D \cdot x_{LNS} + B_x$ in die arithmetisch codierte Ganzzahl $x_c$ codiert.

In dem Schritt 303 wird eine codierte Operation auf die Anzahl N von arithmetisch codierten Ganzzahlen $x_c$, $y_c$ angewendet.

Die codierte Operation umfasst dabei insbesondere eine codierte Additions-Operation CADD und/oder eine Subtraktions-Operation CSUB.

Fig. 4 zeigt ein schematisches Blockdiagramm eines Ausführungsbeispiels einer Vorrichtung 10 zum Verarbeiten von Daten. Die Vorrichtung 10 umfasst eine Wandel-Einheit 11 sowie eine Codier-Einheit 12.

Die Wandel-Einheit 11 ist dazu eingerichtet, eine uncodierte reelle Zahl x in eine LNS-codierte Ganzzahl $x_{LNS}$ mittels einer vorbestimmten Wandelvorschrift für ein logarithmisches Zahlensystem, LNS, gemäß der Gleichung (1)

$$x_{LNS} = \text{sgn}(x) \cdot 2^m + \text{ld}|x| \cdot 2^n \qquad\qquad (1)$$

zu wandeln.

Insbesondere ist die Wandel-Einheit 11 dazu eingerichtet, die Verfahrensschritte 101, 201 und 301 gemäß den Fig. 1, 2 und 3 auszuführen und insbesondere auch weitere uncodierte reelle Zahlen zu wandeln.

Die Codier-Einheit 12 ist dazu eingerichtet, die LNS-codierte Ganzzahl $x_{LNS}$ mittels einer arithmetischen Codierung in eine arithmetisch codierte Ganzzahl $x_c$ zu codieren.

Insbesondere ist die Codier-Einheit 12 dazu eingerichtet, die Verfahrensschritte 102, 202 und 302 gemäß den Fig. 1, 2 und 3 auszuführen und insbesondere auch weitere LNS-codierte Ganzzahlen zu codieren.

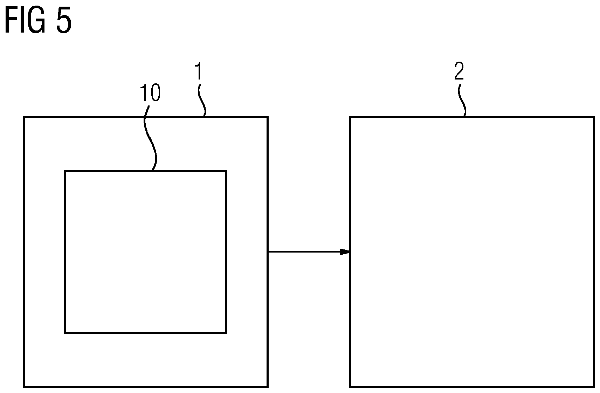

Fig. 5 zeigt ein schematisches Blockdiagramm eines Ausführungsbeispiels einer funktional sicheren, programmierbaren Steuerung 1.

Die Steuerung 1 ist dazu eingerichtet, eine Maschine 2, zum Beispiel ein Förderband oder einen Roboterarm, anzusteuern. Hierzu weist die Steuerung 1 der Fig. 5 eine wie zur Fig. 4 beschriebene Vorrichtung 10 zum Verarbeiten von Daten auf.

Obwohl die vorliegende Erfindung anhand von Ausführungsbeispielen beschrieben wurde, ist sie vielfältig modifizierbar.

Bezugszeichenliste

| | |
|---|---|
| 1 | Steuerung |
| 2 | Maschine |
| 10 | Vorrichtung |
| 11 | Wandel-Einheit |
| 12 | Codier-Einheit |

| | |
|---|---|
| 101 - 102 | Verfahrensschritte |
| 201 - 203 | Verfahrensschritte |
| 301 - 303 | Verfahrensschritte |

Referenzenliste

[1] Siti Zarina Md Naziri, Rizalafande Che Ismail, Ali Yeon Md Shakaff: Implementation of LNS Addition and Subtraction Function with Co-transformation in Positive and Negative Region: A Comparative Analysis, In: 3rd International Conference on Electronic Design (ICED), 2016

[2] J. Nicholas Coleman, Chris I. Softley, Jiri Kadlec, Rudolf Matousek, Milan Tichy, Zdenek Pohl, Antonin Hermanek, Nico F. Benschop: The European Logarithmic Microprocessor, In: IEEE TRANSACTIONS ON COMPUTERS, VOL. 57, NO. 4, APRIL 2008

[3] William A. Chren JR.: Method for reducing memory size in logarithmic number system arithmetic units, US 2006/0106905 A1, May 18, 2006

[4] Michael Haselman: A Comparison of Floating Point and Logarithmic Number Systems on FPGAs, Master Thesis, University of Washingtonm 2005

[5] J.N. Coleman, E.I. Chester, C.I. Softley, and J. Kadlec: Arithmetic on the European Logarithmic Microprocessor, In: IEEE TRANSACTIONS ON COMPUTERS, VOL. 49, NO. 7, JULY 2000

[6] J.N. Coleman and E.I. Chester: A 32-Bit Logarithmic Arithmetic Unit and Its Performance Compared to Floating-Point, In: Proceedings 14th IEEE Symposium on Computer Arithmetic, 1999

[7] J.N. Coleman: Simplification of table structure in logarithmic arithmetic, In: IEEE Electronics Letters (Volume: 31, Issue: 22, 1995

**Patentansprüche**

1. Auf einer programmgesteuerten Einrichtung implementiertes Verfahren zum Verarbeiten von Daten, mit den Schritten:

   - Wandeln (101, 201, 301) einer uncodierten reellen Zahl x in eine LNS-codierte Ganzzahl $x_{LNS}$ mittels einer vorbestimmten Wandelvorschrift für ein logarithmisches Zahlensystem, LNS, gemäß der Gleichung

$$x_{LNS} = sgn(x) \cdot 2^m + ld|x| \cdot 2^n,$$

   wobei sgn(x) eine Vorzeichenfunktion der uncodierten reellen Zahl x, ld|x| einen Zweierlogarithmus der uncodierten reellen Zahl x, m einen ersten Exponenten und n einen zweiten Exponenten bezeichnen, und
   - Codieren (102, 202, 302) der LNS-codierten Ganzzahl $x_{LNS}$ mittels einer arithmetischen Codierung in eine arithmetisch codierte Ganzzahl $x_c$,

   wobei die arithmetische Codierung als ANBD-Codierung oder als DNB-Codierung ausgebildet und eingerichtet ist.

2. Verfahren nach Anspruch 1,
   **dadurch gekennzeichnet,**
   **dass** die reelle Zahl x als eine Ganzzahl von einem Sensor oder als eine Fließkommazahl von dem Sensor oder als eine Fließkommazahl oder als ein String durch eine Eingabe eines Benutzers oder als Konstante eines Programmcodes erhalten wird.

3. Verfahren nach Anspruch 1 oder 2,
   **dadurch gekennzeichnet,**
   **dass** die uncodierte reelle Zahl x während eines Kompiliervorgangs zu der LNS-codierten Ganzzahl $x_{LNS}$ gewandelt wird.

4. Verfahren nach einem der Ansprüche 1 bis 3,
   **dadurch gekennzeichnet,**
   **dass** die LNS-codierte Ganzzahl $x_{LNS}$ während eines Kompiliervorgangs zu der arithmetisch codierten Ganzzahl $x_c$ codiert wird.

5. Verfahren nach einem der Ansprüche 1 bis 4,
   **gekennzeichnet durch**,

   - Wandeln (101, 201, 301) einer Anzahl N, mit N ≥ 1, von uncodierten reellen Zahlen x, y mittels der vorbestimmten Wandelvorschrift in eine entsprechende Anzahl N von LNS-codierten Ganzzahlen $x_{LNS}$, $y_{LNS}$,
   - Codieren (102, 202, 302) der Anzahl N von LNS-codierten Ganzzahlen $x_{LNS}$, $y_{LNS}$ mittels der arithmetischen Codierung in die entsprechende Anzahl N von arithmetisch codierten Ganzzahlen $x_c$, $y_c$, und
   - Anwenden (203, 303) einer codierten Operation auf die Anzahl N von arithmetisch codierten Ganzzahlen $x_c$, $y_c$.

6. Verfahren nach einem der Ansprüche 1 bis 5,
   **dadurch gekennzeichnet,**
   **dass** als die arithmetische Codierung die ANBD-Codierung verwendet wird, welche die LNS-codierte Ganzzahl $x_{LNS}$ mittels einer Eingangskonstanten A, einer variablen-spezifischen Signatur $B_x$ und einer zyklus-spezifischen Signatur D gemäß der Gleichung

$$x_c = A \cdot x_{LNS} + B_x + D$$

   in die arithmetisch codierte Ganzzahl $x_c$ codiert (202).

**7.** Verfahren nach den Ansprüchen 5 und 6,
**dadurch gekennzeichnet,**
**dass** die codierte Operation eine codierte Additions-Operation CADD umfasst, bei welcher die arithmetisch codierte Ganzzahl $x_c$, die arithmetisch codierte Ganzzahl $y_c$ und ein erster Parameter $K_1$ unter Verwendung der zyklus-spezifischen Signatur D addiert werden, um ein Ergebnis einer Addition $(x + y)_c$ der arithmetisch codierten Ganzzahlen $x_c$, $y_c$ gemäß der Gleichung

$$(x + y)_c = x_c + y_c + K_1 - D$$

zu berechnen, wobei der erste Parameter $K_1$ mittels einer für die arithmetisch codierte Ganzzahl $x_c$ spezifischen Signatur $B_x$, einer für die arithmetisch codierte Ganzzahl $y_c$ spezifischen Signatur $B_y$ und einer für eine arithmetisch codierte Ganzzahl $z_c$ spezifischen Signatur $B_z$ gemäß der Gleichung

$$K_1 = B_{x+y} - B_x - B_z$$

berechnet wird (203).

**8.** Verfahren nach einem der Ansprüche 1 bis 5,
**dadurch gekennzeichnet,**
**dass** als die arithmetische Codierung die DNB-Codierung verwendet wird, welche die LNS-codierte Ganzzahl $x_{LNS}$ mittels einer zyklus-spezifischen Signatur D und einer variablen-spezifischen Signatur $B_x$ gemäß der Gleichung

$$x_c = D \cdot x_{LNS} + B_x$$

in die arithmetisch codierte Ganzzahl $x_c$ codiert (302).

**9.** Verfahren nach den Ansprüchen 5 und 8,
**dadurch gekennzeichnet,**
**dass** die codierte Operation eine codierte Additions-Operation CADD umfasst, bei welcher die arithmetisch codierte Ganzzahl $x_c$ und die arithmetisch codierte Ganzzahl $y_c$ unter Verwendung eines zweiten Parameters $K_2$ zu einer arithmetisch codierten Ganzzahl $z_c$ gemäß der Gleichung

$$z_c = (x_c + y_c + K_2)$$

addiert werden, wobei der zweite Parameter $K_2$ mittels einer für die arithmetisch codierte Ganzzahl $x_c$ spezifischen Signatur $B_x$, einer für die arithmetisch codierte Ganzzahl $y_c$ spezifischen Signatur $B_y$ und einer für die arithmetisch codierte Ganzzahl spezifischen Signatur $B_z$ gemäß der Gleichung

$$K_2 = B_z - B_x - B_y$$

berechnet wird (303).

**10.** Verfahren nach den Ansprüchen 5 und 8,
**dadurch gekennzeichnet,**
**dass** die codierte Operation eine codierte Subtraktions-Operation CSUB umfasst, bei welcher eine Differenz zwischen der arithmetisch codierten Ganzzahl $x_c$ und der arithmetisch codierten Ganzzahl $y_c$ unter Verwendung eines dritten Parameters $K_3$ zur Bereitstellung einer arithmetisch codierten Ganzzahl $z_c$ gemäß der Gleichung

$$z_c = (x_c - y_c + K_3)$$

berechnet wird, wobei der dritte Parameter $K_3$ mittels einer für

die arithmetisch codierte Ganzzahl $x_c$ spezifischen Signatur $B_x$, einer für die arithmetisch codierte Ganzzahl $y_c$ spezifischen Signatur $B_y$ und einer für die arithmetisch codierte Ganzzahl spezifischen Signatur $B_z$ gemäß der Gleichung

$$K_3 = B_z - B_x + B_y$$

berechnet wird (303).

11. Computerprogrammprodukt, welches auf einer programmgesteuerten Einrichtung die Durchführung des Verfahrens nach einem der Ansprüche 1 bis 10 veranlasst.

12. Vorrichtung (10) zum Verarbeiten von Daten, mit:

einer Wandel-Einheit (11), welche dazu eingerichtet ist,
eine uncodierte reelle Zahl x in eine LNS-codierte Ganzzahl $x_{LNS}$ mittels einer vorbestimmten Wandelvorschrift für ein logarithmisches Zahlensystem, LNS, gemäß der Gleichung

$$x_{LNS} = sgn(x) \cdot 2^m + ld|x| \cdot 2^n,$$

zu wandeln, wobei sgn(x) eine Vorzeichenfunktion der uncodierten reellen Zahl x, ld|x| einen Zweierlogarithmus der uncodierten reellen Zahl x, einen ersten Exponenten m und einen zweiten Exponenten n bezeichnen, und
einer Codier-Einheit (12), welche dazu eingerichtet ist, die LNS-codierte Ganzzahl $x_{LNS}$ mittels einer arithmetischen Codierung in eine arithmetisch codierte Ganzzahl $x_c$ zu codieren, wobei die arithmetische Codierung als ANBD-Codierung oder als DNB-Codierung ausgebildet und eingerichtet ist.

13. Vorrichtung nach Anspruch 12,
**dadurch gekennzeichnet,**

**dass** die Vorrichtung zur Durchführung eines Verfahrens gemäß einem der Ansprüche 1 bis 10 ausgebildet und eingerichtet ist,
und/oder
**dass** die Vorrichtung ein Computerprogrammprodukt gemäß Anspruch 11 umfasst.

14. Funktional sichere, programmierbare Steuerung (1) mit einer Vorrichtung (10) nach Anspruch 12 oder 13.

**Claims**

1. Method for processing data, implemented on a program-controlled device and having the steps of:

- converting (101, 201, 301) an uncoded real number x into an LNS-coded integer $x_{LNS}$ by means of a predetermined conversion rule for a logarithmic number system, LNS, according to the equation

$$x_{LNS} = sgn(x) \cdot 2^m + ld|x| \cdot 2^n,$$

where sgn(x) denotes a sign function of the uncoded real number x, ld|x| denotes a binary logarithm of the uncoded real number x, m denotes a first exponent and n denotes a second exponent, and
- coding (102, 202, 302) the LNS-coded integer $x_{LNS}$ into an arithmetically coded integer $x_c$ by means of arithmetic coding, wherein the arithmetic coding is designed and configured as ANBD coding or as DNB coding.

2. Method according to Claim 1,
**characterized**
**in that** the real number x is received as an integer from a sensor or as a floating point number from the sensor or as a floating point number or as a string as a result of an input by a user or as a constant of a program code.

**3.** Method according to Claim 1 or 2,
**characterized**
**in that** the uncoded real number x is converted into the LNS-coded integer $x_{LNS}$ during a compiling process.

**4.** Method according to any of Claims 1 to 3,
**characterized**
**in that** the LNS-coded integer $x_{LNS}$ is coded to form the arithmetically coded integer $x_c$ during a compiling process.

**5.** Method according to any of Claims 1 to 4,
**characterized by**

- converting (101, 201, 301) a number N, where N $\geq$ 1, of uncoded real numbers x, y into a corresponding number N of LNS-coded integers $x_{LNS}$, $y_{LNS}$ by means of the predetermined conversion rule,
- coding (102, 202, 302) the number N of LNS-coded integers $x_{LNS}$, $y_{LNS}$ into the corresponding number N of arithmetically coded integers $x_c$, $y_c$ by means of the arithmetic coding, and
- applying (203, 303) a coded operation to the number N of arithmetically coded integers $x_c$, $y_c$.

**6.** Method according to any of Claims 1 to 5,
**characterized**
**in that** ANBD coding is used as the arithmetic coding and codes (202) the LNS-coded integer $x_{LNS}$ into the arithmetically coded integer $x_c$ by means of an input constant A, a variable-specific signature $B_x$ and a cycle-specific signature D according to the equation

$$x_c = A \cdot x_{LNS} + B_x + D.$$

**7.** Method according to Claims 5 and 6,
**characterized**

**in that** the coded operation comprises a coded addition operation CADD in which the arithmetically coded integer $x_c$, the arithmetically coded integer $y_c$ and a first parameter $K_1$ are added using the cycle-specific signature D in order to calculate a result of an addition $(x + y)_c$ of the arithmetically coded integers $x_c$, $y_c$ according to the equation

$$(x + y)_c = x_c + y_c + K_1 - D,$$

where the first parameter $K_1$ is calculated (203) by means of a signature $B_x$ specific to the arithmetically coded integer $x_c$, a signature $B_y$ specific to the arithmetically coded integer $y_c$ and a signature $B_z$ specific to an arithmetically coded integer $z_c$ according to the equation

$$K_1 = B_{x+y} - B_x - B_z.$$

**8.** Method according to any of Claims 1 to 5,
**characterized**
**in that** DNB coding is used as the arithmetic coding and codes (302) the LNS-coded integer $x_{LNS}$ into the arithmetically coded integer $x_c$ by means of a cycle-specific signature D and a variable-specific signature $B_x$ according to the equation

$$x_c = D \cdot x_{LNS} + B_x.$$

**9.** Method according to Claims 5 and 8,
**characterized**

**in that** the coded operation comprises a coded addition operation CADD in which the arithmetically coded integer $x_c$ and the arithmetically coded integer $y_c$ are added using a second parameter $K_2$ to form an arithmetically coded integer $z_c$ according to the equation

$$z_c = (x_c + y_c + K_2),$$

where the second parameter $K_2$ is calculated (303) by means of a signature $B_x$ specific to the arithmetically coded integer $x_c$, a signature $B_y$ specific to the arithmetically coded integer $y_c$ and a signature $B_z$ specific to the arithmetically coded integer according to the equation

$$K_2 = B_z - B_x - B_y.$$

10. Method according to Claims 5 and 8,
**characterized**

**in that** the coded operation comprises a coded subtraction operation CSUB in which a difference between the arithmetically coded integer $x_c$ and the arithmetically coded integer $y_c$ is calculated using a third parameter $K_3$ in order to provide an arithmetically coded integer $z_c$ according to the equation

$$z_c = (x_c - y_c + K_3),$$

where the third parameter $K_3$ is calculated (303) by means of a signature $B_x$ specific to the arithmetically coded integer $x_c$, a signature $B_y$ specific to the arithmetically coded integer $y_c$ and a signature $B_z$ specific to the arithmetically coded integer according to the equation

$$K_3 = B_z - B_x + B_y.$$

11. Computer program product that causes the method according to one of Claims 1 to 10 to be performed on a program-controlled device.

12. Apparatus (10) for processing data, having:

a conversion unit (11) which is set up to convert an uncoded real number x into an LNS-coded integer $x_{LNS}$ by means of a predetermined conversion rule for a logarithmic number system, LNS, according to the equation

$$x_{LNS} = sgn(x) \cdot 2^m + ld|x| \cdot 2^n,$$

where $sgn(x)$ denotes a sign function of the uncoded real number x, $ld|x|$ denotes a binary logarithm of the uncoded real number x, m denotes a first exponent and n denotes a second exponent, and
a coding unit (12) which is set up to code the LNS-coded integer $x_{LNS}$ into an arithmetically coded integer $x_c$ by means of arithmetic coding, wherein the arithmetic coding is designed and configured as ANBD coding or as DNB coding.

13. Apparatus according to Claim 12,
**characterized**

**in that** the apparatus is designed and configured to perform a method according to any of Claims 1 to 10 and/or
**in that** the apparatus comprises a computer program product according to Claim 11.

14. Functionally safe programmable controller (1) having an apparatus (10) according to Claim 12 or 13.

**Revendications**

1. Procédé implémenté sur un dispositif piloté par un programme pour le traitement de données, comprenant les étapes :

   - de transformation (101, 201, 301) d'un nombre réel non encodé x en un nombre entier encodé par LNS $x_{LNS}$ au moyen d'une procédure de transformation prédéfinie pour un système de numération logarithmique, LNS, conformément à l'équation

   $$x_{LNS} = \text{sgn}(x) \cdot 2^m + \text{ld}|x| \cdot 2^n,$$

   dans lequel sgn(x) désigne une fonction signe du nombre réel non encodé x, ld|x| un logarithme binaire du nombre réel non encodé x, m un premier exposant et n un deuxième exposant, et
   - d'encodage (102, 202, 302) du nombre entier encodé par LNS $x_{LNS}$ au moyen d'un encodage arithmétique en un nombre entier encodé arithmétiquement $x_c$,

   dans lequel l'encodage arithmétique est conçu et organisé en tant qu'encodage ANBD ou en tant qu'encodage DNB.

2. Procédé selon la revendication 1,
   **caractérisé en ce que** le nombre réel x est obtenu en tant que nombre entier par un capteur ou en tant qu'un nombre à virgule flottante par le capteur ou en tant qu'un nombre à virgule flottante ou en tant qu'une chaîne de caractères par une saisie d'un utilisateur ou en tant que constante d'un code de programme.

3. Procédé selon la revendication 1 ou 2,
   **caractérisé en ce que** le nombre réel non encodé x est transformé en le nombre entier encodé par LNS $x_{LNS}$ pendant une procédure de compilation.

4. Procédé selon l'une des revendications 1 à 3,
   **caractérisé en ce que** le nombre entier encodé par LNS $x_{LNS}$ est encodé en le nombre entier encodé arithmétiquement $x_c$ pendant une procédure de compilation.

5. Procédé selon l'une des revendications 1 à 4,
   **caractérisé par**

   - la transformation (101, 201, 301) d'un nombre N, avec N ≥ 1, de nombres réels non encodés x, y au moyen de la procédure de transformation prédéfinie en un nombre correspondant N de nombres entiers encodés LNS $x_{LNS}$, $y_{LNS}$,
   - l'encodage (102, 202, 302) du nombre N de nombres entiers encodés LNS $x_{LNS}$, $y_{LNS}$ au moyen de l'encodage arithmétique en le nombre correspondant N de nombres entiers encodés arithmétiquement $x_c$, $y_c$, et
   - l'application (203, 303) d'une opération encodée sur le nombre N de nombres entiers encodés arithmétiquement $x_c$, $y_c$.

6. Procédé selon l'une des revendications 1 à 5,
   **caractérisé en ce que**

   l'encodage ANBD est employé en tant que l'encodage arithmétique, lequel encode (202) le nombre entier encodé par LNS $x_{LNS}$ au moyen d'une constante d'entrée A, d'une signature à variable spécifique $B_x$ et d'une signature à cycle spécifique D selon l'équation

   $$x_c = A \cdot x_{LNS°} + B_x + D$$

   en le nombre entier encodé arithmétiquement $x_c$.

7. Procédé selon les revendications 5 et 6,
   **caractérisé en ce que**

   l'opération encodée comprend une opération d'additions encodée CADD, dans laquelle le nombre entier encodé arithmétiquement $x_c$, le nombre entier encodé arithmétiquement $y_c$ et un premier paramètre $K_1$ sont additionnés en utilisant la signature à cycle spécifique D pour calculer un résultat d'une addition $(x + y)_c$ des nombres entiers encodés arithmétiquement $x_c$, $y_c$ selon l'équation

$$(x + y)_c = x_c + y_c + K_1 - D,$$

dans lequel le premier paramètre $K_1$ est calculé (203) au moyen d'une signature $B_x$ spécifique au nombre entier encodé arithmétiquement $x_c$, d'une signature $B_y$ spécifique au nombre entier encodé arithmétiquement $y_c$ et d'une signature $B_z$ spécifique à un nombre entier encodé arithmétiquement $z_c$ selon l'équation

$$K_1 = B_{x+y} - B_x - B_z.$$

**8.** Procédé selon l'une des revendications 1 à 5,
**caractérisé en ce que**

l'encodage DNB est employé en tant que l'encodage arithmétique, lequel encode (302) le nombre entier encodé par LNS $x_{LNS}$ au moyen d'une signature à cycle spécifique D et d'une signature $B_x$ à variable spécifique selon l'équation

$$x_c = D \cdot x_{LNS} + B_x$$

en le nombre entier encodé arithmétiquement $x_c$.

**9.** Procédé selon les revendications 5 et 8,
**caractérisé en ce que**

l'opération encodée comprend une opération d'additions encodée CADD, dans laquelle le nombre entier encodé arithmétiquement $x_c$ et le nombre entier encodé arithmétiquement $y_c$ sont additionnés en utilisant un deuxième paramètre $K_2$ sur un nombre entier encodé arithmétiquement $z_c$ selon l'équation

$$z_c = (x_c + y_c + K_2),$$

dans lequel le deuxième paramètre $K_2$ est calculé (303) au moyen d'une signature $B_x$ spécifique au nombre entier encodé arithmétiquement $x_c$, d'une signature $B_y$ spécifique au nombre entier encodé arithmétiquement $y_c$ et d'une signature $B_z$ spécifique au nombre entier encodé arithmétiquement selon l'équation

$$K_2 = B_z - B_x - B_y.$$

**10.** Procédé selon les revendications 5 et 8,
**caractérisé en ce que**

l'opération encodée comprend une opération de soustraction encodée CSUB dans laquelle une différence entre le nombre entier encodé arithmétiquement $x_c$ et le nombre entier encodé arithmétiquement $y_c$ est calculée en utilisant un troisième paramètre $K_3$ pour fournir un nombre entier encodé arithmétiquement $z_c$ selon l'équation

$$z_c = (x_c - y_c + K_3),$$

dans lequel le troisième paramètre $K_3$ est calculé (303) au moyen d'une signature $B_x$ spécifique au nombre entier encodé arithmétiquement $x_c$, d'une signature $B_y$ spécifique au nombre entier encodé arithmétiquement $y_c$ et d'une signature $B_z$ spécifique au nombre entier encodé arithmétiquement selon l'équation

$$K_3 \; = \; B_z \; - \; B_x \; + \; B_y.$$

11. Produit de programme informatique, lequel déclenche l'exécution du procédé selon l'une des revendications 1 à 10 sur un dispositif piloté par un programme.

12. Dispositif (10) pour le traitement de données, comprenant :

une unité de transformation (11) qui est conçue pour transformer un nombre réel non encodé x en un nombre entier encodé par LNS $x_{LNS}$ au moyen d'une procédure de transformation prédéfinie pour un système de numération logarithmique, LNS, conformément à l'équation

$$x_{LNS} = \mathrm{sgn}(x) \; \cdot \; 2^m + \mathrm{ld}|x| \; \cdot \; 2^n,$$

dans lequel sgn(x) désigne une fonction signe du nombre réel non encodé x, ld|x| un logarithme binaire du nombre réel non encodé x, un premier exposant m et un deuxième exposant n, et
une unité d'encodage (12) qui est conçue pour encoder le nombre entier encodé par LNS $x_{LNS}$ au moyen d'un encodage arithmétique en un nombre entier encodé arithmétiquement $x_c$,
dans lequel l'encodage arithmétique est conçu et organisé en tant qu'encodage ANBD ou en tant qu'encodage DNB.

13. Dispositif selon la revendication 12,
**caractérisé en ce que**

le dispositif est conçu et organisé pour exécuter un procédé selon l'une des revendications 1 à 10,
et/ou
que le dispositif comprend un produit de programme informatique selon la revendication 11.

14. Commande (1) programmable et à sécurité fonctionnelle comprenant un dispositif (10) selon la revendication 12 ou 13.

FIG 1

FIG 2

## FIG 3

## FIG 4

FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3104276 A1
- DE 102018189988
- US 20060106905 A1


**In der Beschreibung aufgeführte Nicht-Patentliteratur**

- Hardware Error Detection Using AN-Codes. *Dissertation,* 10. Juni 2011
- **SITI ZARINA MD NAZIRI ; RIZALAFANDE CHE ISMAIL ; ALI YEON MD SHAKAFF.** Implementation of LNS Addition and Subtraction Function with Co-transformation in Positive and Negative Region: A Comparative Analysis. *3rd International Conference on Electronic Design (ICED),* 2016
- **J. NICHOLAS COLEMAN ; CHRIS I. SOFTLEY ; JIRI KADLEC ; RUDOLF MATOUSEK ; MILAN TICHY ; ZDENEK POHL ; ANTONIN HERMANEK ; NICO F. BENSCHOP.** The European Logarithmic Microprocessor. *IEEE TRANSACTIONS ON COMPUTERS,* 04. April 2008, vol. 57
- **WILLIAM A. CHREN JR.** *Method for reducing memory size in logarithmic number system arithmetic units*
- A Comparison of Floating Point and Logarithmic Number Systems on FPGAs. **MICHAEL HASELMAN.** Master Thesis. University of Washingtonm, 2005
- **J.N. COLEMAN ; E.I. CHESTER ; C.I. SOFTLEY ; J. KADLEC.** Arithmetic on the European Logarithmic Microprocessor. *IEEE TRANSACTIONS ON COMPUTERS,* 07. Juli 2000, vol. 49
- **J.N. COLEMAN ; E.I. CHESTER.** A 32-Bit Logarithmic Arithmetic Unit and Its Performance Compared to Floating-Point. *Proceedings 14th IEEE Symposium on Computer Arithmetic,* 1999
- **J.N. COLEMAN.** Simplification of table structure in logarithmic arithmetic. *IEEE Electronics Letters,* 1995, vol. 31 (22